# DEMANDE DE BREVET EUROPEEN

(11) **EP 0 606 799 A1**
(43) Date de publication de la demande: **20.07.1994**
(21) Numéro de dépôt: 93403115.4
(22) Date de dépôt: 21.12.1993
(51) Int. Cl.: H03M 1/14, H03M 1/36, H03M 1/34

(54) **Convertisseur analogique numérique avec échantillonneur bloqueur distribué**

(30) Priorité: 30.12.1992 FR 9215906
(71) Demandeur: THOMSON-CSF SEMICONDUCTEURS SPECIFIQUES, 75008 Paris (FR)
(72) Inventeur: Wingender, Marc, F-92402 Courbevoie Cedex (FR)
(74) Mandataire: Guérin, Michel

(57) **Abrégé**

L'invention concerne les convertisseurs analogique numérique.

On veut limiter la consommation de puissance et améliorer le compromis entre les différentes performances du convertisseur. Une structure générale de convertisseur consiste à avoir d'une part un convertisseur grossier pour les bits de poids fort et d'autre part un convertisseur fin pour les bits de poids faibles ; l'un d'eux (en général le convertisseur fin), comporte des amplificateurs différentiels [AD(1) à AD(N)] recevant la tension à convertir (Ve) et une tension de référence. On propose selon l'invention de placer des échantillonneurs-bloqueurs [EB(1) à EB(N)] en sortie de ces amplificateurs différentiels et de supprimer l'échantillonneur-bloqueur souvent prévu en amont de ces amplificateurs.

## Description

L'invention concerne les convertisseurs analogiques numériques, c'est-à-dire les circuits électroniques permettant de convertir un signal d'entrée analogique en une valeur numérique précise représentant l'amplitude du signal analogique. La valeur numérique est obtenue sous forme d'un mot de plusieurs bits, en général codé en binaire pur.

Plusieurs procédés de conversion existent, et le choix d'un procédé plutôt qu'un autre dépend des performances que l'on attend du convertisseur. Les paramètres les plus importants de ces performances sont :
- la résolution, définie par le nombre de bits du mot de sortie représentant avec exactitude l'amplitude du signal analogique ; le nombre de bits peut être de 16 à 18, voire même 20, pour les convertisseurs les plus précis, et la précision est en général de + ou - 1/2 bit de poids le plus faible ;
- la rapidité, c'est-à-dire le nombre d'opérations de conversion qu'on peut effectuer en une seconde;
- la consommation de puissance : un convertisseur rapide et précis consomme beaucoup plus d'énergie qu'un convertisseur lent et peu précis ; or la consommation de puissance entraîne un échauffement de la puce de circuit-intégré sur laquelle est réalisé le convertisseur. Cet échauffement doit être compensé par des moyens de refroidissement qui rendent le circuit difficilement utilisable lorsqu'il y a des contraintes d'encombrement à respecter;
- et bien sûr le coût de conception et de fabrication du convertisseur, lié en particulier à la surface de puce de circuit intégré utilisée par le convertisseur.

Les qualités d'un convertisseur analogique-numérique résultent d'un compromis entre les paramètres ci-dessus et un but de la présente invention est d'améliorer ce compromis.

Parmi les structures connues de convertisseurs analogiques-numériques, on peut citer :
- les convertisseurs à approximations successives, qui comparent le signal analogique d'entrée Vin successivement à des valeurs numériques approchant à chaque fois un peu mieux la valeur du signal analogique ; ces convertisseurs fonctionnent en au moins N phases si la valeur est codée sur N bits ; ils sont donc en général très lents pour des précisions dépassant 6 ou 8 bits.
- les convertisseurs "flash", qui utilisent 2^{N} comparateurs en parallèle ; les comparateurs reçoivent chacun d'une part le signal analogique et d'autre part l'une de 2^{N} tensions de références définies par un pont de 2^{N} résistances de précision ; ces convertisseurs sont très rapides (2 phases en général) mais ils sont très encombrants et consomment une puissance très importante lorsque N atteint 10 à 12 bits ;
- les convertisseurs mixtes ayant un convertisseur grossier pour l'obtention des bits de poids fort et un convertisseur fin pour l'obtention des bits de poids faible ; le convertisseur grossier peut être rapide et peu précis (4 à 6 bits par exemple); le convertisseur fin doit être précis même s'il est moins rapide.

Parmi les convertisseurs mixtes, on a déjà proposé plusieurs solutions.

Dans une solution, le convertisseur grossier est un convertisseur flash qui fournit P bits qui sont les bits de poids fort. Cette valeur est reconvertie en signal analogique par un convertisseur numérique-analogique de P bits ; la différence entre le signal analogique Vin et cette valeur reconvertie, appelée aussi reste ou résidu, est convertie par un convertisseur fin qui détermine les bits de poids faible de la conversion ; on gagne en consommation de puissance et encombrement par rapport à un convertisseur flash, mais la conversion numérique analogique prend du temps et nécessite un asservissement précis des gains des différentes parties de circuit (convertisseur analogique-numérique et numérique- analogique).

Dans une autre architecture de convertisseur mixte, on utilise ce qu'on appelle un convertisseur à repliement du signal analogique d'entrée ; le signal d'entrée Vin est appliqué à au moins deux circuits de repliement, dont la fonction est de fournir des signaux dits "repliés" Vr1, Vr1b, Vr2, Vr2b, ayant une amplitude qui varie avec l'amplitude du signal d'entrée Vin selon une fonction périodique (de forme à peu près sinusoïnale). Les différences (Vr1-Vr1b), (Vr2-Vr2b) entre les signaux repliés issus des deux blocs, s'annulent périodiquement pour des valeurs de tension d'entrée qui sont des tensions de référence définies par un pont de résistances; à partir de ces différences, on établit des signaux dits "interpolés", de même allure générale que les différences de signaux repliés, mais qui s'annulent pour des valeurs de tension d'entrée intermédiaires entre les valeurs de référence.

Les signaux interpolés permettent alors d'obtenir les poids faibles de la conversion numérique-analogique, représentant la position de Vin par rapport à ces valeurs de référence intermédiaires. Les poids forts sont donnés par un convertisseur grossier qui indique dans quelle "période" des signaux repliés se situe la tension d'entrée analogique Vin, c'est-à-dire qui indique entre quelles valeurs adjacentes de tensions de référence se situe Vin.

Dans une architecture déjà proposée, le circuit d'interpolation comporte de simples ponts de résistances qui reçoivent par exemple les différences (Vr1-Vr2) et (Vr1b-Vr2b) entre les signaux repliés. Les prises intermédiaires de ces ponts de résistances fournissent les signaux interpolés ; elles sont appliquées deux à deux à des comparateurs qui basculent dans un sens ou dans l'autre selon la valeur des signaux interpolés donc selon la position de Vin entre deux tensions de références adjacentes.

Dans une autre architecture, le circuit d'interpolation comporte plusieurs étages en cascade ; le premier étage reçoit les quatre signaux repliés et les combine de manière à produire quatre autres signaux qui sont encore des fonctions périodiques de la tension analogique d'entrée Vin, mais avec cette fois une période double de la période des signaux repliés : ces nouveaux signaux passent par zéro non seulement lorsque Vin est égale aux tensions de référence ayant servi au repliement, mais aussi pour des tensions de référence intermédiaires situées au milieu de l'intervalle entre deux tensions de référence adjacentes. Les signaux permettent donc de fournir un bit d'information supplémentaire par rapport aux bits de poids forts obtenus par le convertisseur grossier. Les tensions ainsi obtenues en sortie du premier étage, sont appliquées à un deuxième étage qui a la même fonction (création de signaux de période à nouveau doublée) et qui fournit un bit supplémentaire pour la valeur de Vin. Ainsi de suite, plusieurs étages peuvent être mis en cascade pour obtenir les bits successifs de poids faible de la conversion. Il semble que le brevet US 5 126 742 décrit une architecture de ce type.

Enfin, dans une architecture récemment proposée par la Demanderesse, on a un convertisseur mixte dans lequel le même pont de résistances sert à la fois de référence pour un convertisseur grossier et pour l'interpolation fine (demande de brevet FR 92 14640).

Dans la plupart des architectures de convertisseurs mixtes, il est nécessaire de prévoir que le signal analogique à convertir passe au préalable dans un échantillonneur-bloqueur. En effet, les convertisseurs mixtes ont besoin d'une certaine durée pour fournir un résultat complet. Et il ne faut pas que le signal analogique d'entrée varie pendant cette durée, sous peine d'obtenir des résultats qui peuvent être aberrants. Par exemple, dans certaines architectures, la conversion fine ne peut s'effectuer qu'après une phase de reconstruction d'une tension de résidu à partir du résultat d'une conversion grossière : il ne faut pas que le résidu varie en cours de reconstruction. De même, dans les architectures où l'interpolation fine est effectuée par des circuits en série, il ne faut pas que la tension d'entrée varie entre le moment de l'interpolation dans le premier étage et le moment d'interpolation dans les derniers étages.

Un échantillonneur-bloqueur est donc prévu en amont du convertisseur. Il reçoit une tension analogique Ve à convertir et fournit sur sa sortie une tension échantillonnée Vin qui est la valeur de Ve mesurée au début d'une phase de conversion. Cette tension de sortie Vin reste bloquée avec une grande précision pendant tout le temps nécessaire à la conversion, grossière et fine.

Cette tension échantillonnée et bloquée est donc appliquée au convertisseur grossier et est utilisée également par le convertisseur fin.

Mais la réalisation de l'échantillonneur bloqueur est délicate. Sa vitesse de réponse dynamique et sa précision doivent être élevées; il doit être capable d'échantillonner et bloquer un signal analogique variant rapidement suivant de grandes amplitudes; il doit donc présenter de bonnes caractéristiques de linéarité dynamique. D'autre part il doit être capable de commander la capacité d'entrée assez élevée des différents circuits d'entrée du convertisseur : cette capacité résulte de la mise en parallèle de toutes les capacités d'entrée des différents amplificateurs et comparateurs, parfois très nombreux, qui peuvent recevoir en parallèle la tension d'entrée Vin. Cependant, l'échantillonneur-bloqueur ne devra pas consommer une puissance excessive, la dissipation de puissance étant une des limitations les plus importantes dans la réalisation des convertisseurs analogiques numériques de précision.

Toutes ces contraintes font que l'échantillonneur-bloqueur est un élément de circuit presque aussi difficile à réaliser que le convertisseur analogique-numérique à l'entrée duquel il est placé.

Un but de l'invention est de rendre le convertisseur moins dépendant des limitations de performances introduites par l'échantillonneur-bloqueur.

Pour cela, l'invention propose un convertisseur analogique-numérique comportant un convertisseur grossier et un convertisseur fin, l'un des convertisseurs au moins (en principe le convertisseur fin) comportant plusieurs amplificateurs différentiels recevant chacun d'une part une tension analogique à convertir et d'autre part une tension de référence, la particularité de l'invention étant qu'un échantillonneur bloqueur est placé en aval de chacun des amplificateurs différentiels.

Par "amplificateur différentiel", on entend dans la présente demande un élément de circuit de type analogique fournissant une tension analogique représentant la différence entre la tension à convertir et une tension de référence, et non pas un simple comparateur logique basculant dans un sens ou dans l'autre selon le signe de cette différence. Et par "échantillonneur-bloqueur" on entend par conséquent un élément de circuit capable d'échantillonner et maintenir une valeur de tension analogique et non pas simplement une bascule logique capable de basculer dans un état à un instant défini par une horloge et d'y rester jusqu'à un coup d'horloge suivant.

Autrement dit, selon l'invention, on ne se préoccupe plus de bloquer en amont la tension analogique à convertir, mais on bloque les niveaux de tension analogique de sortie de plusieurs étages différentiels qui travaillent en parallèle à partir de cette tension analogique. L'échantillonneur bloqueur global placé à l'entrée du convertisseur est donc supprimé.

Les différents échantillonneurs bloqueurs répartis en sortie des amplificateurs différentiels n'ont plus besoin d'avoir des performances aussi difficiles à obtenir que celles de l'échantillonneur bloqueur de l'art antérieur qui était placé en amont de tous les comparateurs et amplificateurs différentiels des deux convertisseurs (fin et grossier). On pourra de ce fait réduire beaucoup la consommation de puissance globale.

De plus, les échantillonneurs bloqueurs distribués seront attaqués directement par des tensions différentielles en sortie des amplificateurs, ce qui est avantageux : les échantillonneurs bloqueurs qui travaillent en différentiel ont en effet une plus grande précision (meilleur taux de rejections de mode commun, meilleure tenue en blocage) que les autres. Dans la technique antérieure il fallait d'ailleurs souvent commencer par transformer la tension d'entrée en une tension différentielle Ve avant de l'appliquer à un échantillonneur-bloqueur différentiel.

Il devient alors possible d'effectuer la phase d'échantillonnage (simultanément en sortie de tous les amplificateurs différentiels) exactement au moment où la tension d'entrée est convertie par l'autre convertisseur (en principe le convertisseur grossier). On a alors un premier résultat de conversion, obtenu souvent instantanément ou quasi instantanément, en provenance de l'un des convertisseurs, et l'autre convertisseur travaillera, plus lentement, sur la valeur figée qu'avait la tension d'entrée au moment où elle a été convertie par le premier convertisseur.

Ceci est vrai tout particulièrement lorsque le convertisseur grossier est un convertisseur de type flash comportant plusieurs comparateurs actionnés simultanément pour comparer la tension analogique à des références de tension pendant une phase de conversion grossière. Dans ce cas, on prévoira avantageusement que les références de tension des comparateurs et les références de tension des amplificateurs différentiels sont définies par les prises intermédiaires d'un même pont de résistances.

Dans certaines architectures de convertisseur, on prévoit un grand nombre d'amplificateurs différentiels en amont d'un circuit d'interpolation fine pour l'obtention des bits de poids faible, mais seulement trois amplificateurs, sélectionnés en fonction du résultat de la conversion grossière, sont utilisés pour la conversion fine. Si l'échantillonneur bloqueur est unique et placé en amont des amplificateurs, il est chargé par la totalité des capacités d'entrée de ces amplificateurs, même s'ils ne sont pas utilisés; dans le cas de l'invention, on peut envisager de ne faire travailler que les trois échantillonneurs bloqueurs placés en sortie des trois amplificateurs effectivement utilisés. Les autres seront inhibés et ne participeront pas à la dissipation de puissance de l'ensemble.

L'invention est applicable à toutes sortes d'architectures de convertisseurs mixtes, et notamment à celles qui ont été mentionnées ci-dessus, par exemple celles dans lesquelles les amplificateurs différentiels sont des amplificateurs à repliement de signal. Dans ce cas, les échantillonneurs bloqueurs sont placés en sortie de ces amplificateurs à repliement de signal.

D'autres caractéristiques et avantages de l'invention apparaîtront à la lecture de la description détaillée qui suit et qui est faite en référence aux dessins annexés dans lesquels :
- la figure 1 représente une architecture de convertisseur mixte proposée par la Demanderesse dans la demande de brevet FR 92 14 640;
- la figure 2 représente un exemple d'architecture générale de convertisseur selon l'invention.

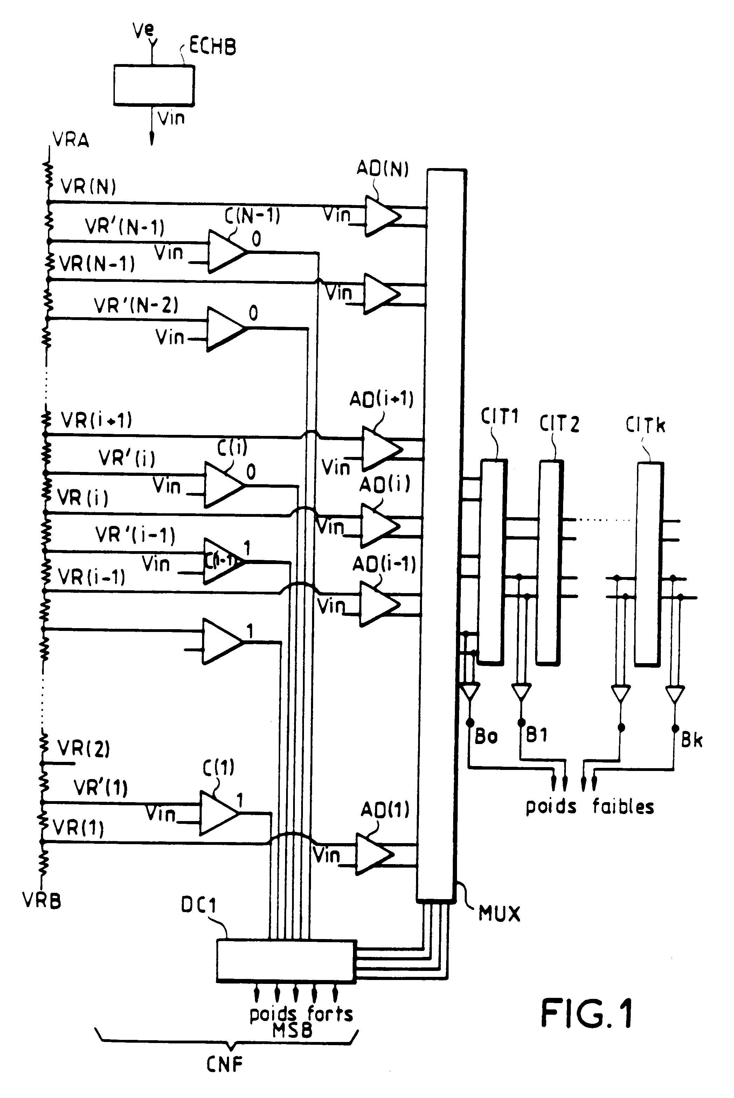

L'architecture de convertisseur mixte représentée à la figure 1 repose sur les principes suivants le convertisseur comporte un pont de résistances de précision alimenté entre deux tensions de référence extrêmes VRA et VRB. Les prises intermédiaires de ce pont définissent d'une part N premières références de tension équidistantes VR(1) VR(2)... VR(i)... VR(N), et d'autre part N-1 secondes références VR'(1), VR'(2),...VR'(i)...VR'(N-1) intermédiaires entre les N premières et de préférence situées au milieu des intervalles successifs entre les premières références. N est égal à 32 si on veut 5 bits de poids fort.

Les N secondes références VR'(1) à VR'(N) sont les références de tension d'un convertisseur analogique-numérique flash CNF qui reçoit par ailleurs un signal d'entrée analogique Vin. Le convertisseur flash est constitué à l'aide de N-1 comparateurs C(1) à C(N-1) et un décodeur DC1. Les comparateurs fournissent N sorties logiques selon un code dit "thermométrique", c'est-à-dire que si Vin est compris par exemple entre VR'(i-1) et VR'(i), alors les i-1 premiers comparateurs de la série fournissent une sortie logique à un premier niveau (1 par exemple) et tous les suivants fournissent l'état complémentaire (0). Le décodeur DC1 placé en sortie des comparateurs C(1) à C(N-1) permet de convertir ce code en un code binaire représentant les poids forts de la valeur numérique du signal analogique Vin.

Les N premières références de tension VR(1) à VR(N) sont appliquées chacune à la première entrée d'un amplificateur différentiel respectif AD(1) à AD(N) qui reçoit sur une autre entrée la tension analogique Vin. Les amplificateurs sont des amplificateurs différentiels classiques; ils fournissent sur leurs deux sorties deux tensions variant symétriquement et de manière monotone sur toute la gamme de variation possible de la tension Vin, ces tensions prenant une valeur commune moyenne Vm lorsque la différence entre leurs tensions d'entrée s'annule.

Le signal d'entrée Vin appliqué à l'entrée des comparateurs et des amplificateurs différentiels est issu d'un échantillonneur bloqueur ECHB qui reçoit la tension analogique à convertir Ve, qui l'échantillonne au début d'une phase de conversion, et qui la bloque pendant toute cette phase.

Les signaux logiques issus du convertisseur flash, en sortie des comparateurs C(1) à C(N-1), ou en sortie du décodeur DC1, servent non seulement à fournir les bits de poids fort de la conversion, mais servent aussi à sélectionner trois amplificateurs différentiels adjacents AD(i-1), AD(i), AD(i+1), dont les références de tension VR(i-1), VR(i), VR(i+1) sont les plus proches de la valeur de codage grossière obtenue pour Vin.

Si Vin est compris entre VR'(i-1) et VR'(i) (qui sont respectivement situées à mi-distance de VR(i-1) et VR(i) d'une part, VR(i) et VR(i+1) d'autre part), alors les trois amplificateurs AD(i-1), AD(i), AD(i+1), qui reçoivent comme références d'entrée VR(i-1), VR(i), VR(i+1), sont sélectionnés. Les sorties de ces trois amplificateurs sont alors connectées, par un multiplexeur analogique MUX, à un premier circuit d'interpolation CIT1. Le multiplexeur est commandé par les sorties du décodeur DC1 ou par les sorties des comparateurs C(1) à C(N-1). Les sorties des autres amplificateurs ne sont pas utilisées.

Le premier circuit d'interpolation fournit quatre tensions différentielles d'interpolation de rang 1, variables continûment en fonction de Vin, variant en sens inverse deux à deux, deux d'entre elles passant par une valeur moyenne et les deux autres présentant l'une un maximum l'autre un minimum lorsque la tension Vin est égale à l'une quelconque des trois tensions de référence principales VR(i-1), VR(i), VR(i+1).

Les sorties du circuit CIT1 sont connectées à un circuit d'interpolation suivant CIT2, qui lui-même est relié à un troisième, etc. On a donc une cascade de k circuits d'interpolation CIT2,...CITk (k = 5 par exemple pour obtenir 7 bits de poids faible). Chaque circuit d'interpolation de rang k reçoit quatre tensions issues d'un circuit d'interpolation de rang k-1, et fournit quatre tensions d'interpolation de rang k, variables en fonction de l'amplitude du signal Vin à convertir; les quatre tensions d'interpolation de rang k varient en sens inverse deux à deux; deux d'entre elles passant par une valeur moyenne commune lorsque la tension Vin à convertir est égale à des valeurs dites "tensions intermédiaires de rang k", et passent l'une par un maximum l'autre par un minimum lorsque la tension Vin à convertir est égale aux valeurs de tension de référence principales ou intermédiaires de rang 1 à k-1; les deux autres tensions d'interpolation de rang k passant par une valeur moyenne commune lorsque la tension Vin est égale à une tension de référence principale ou intermédiaire de rang 1 à k-1.

Des comparateurs CMP0 à CMPk placés en entrée ou sortie des circuits d'interpolation CIT1 à CITk fournissent les bits de poids faible B0 à Bk de la conversion fine.

Par conséquent, le convertisseur flash CNF constitué à l'aide des comparateurs C(1) à C(N-1) fournit une valeur numérique représentant la position de Vin par rapport aux références de tension VR'(1) à VR'(N-1), et ce convertisseur indique donc un triplet de valeurs de référence VR(i-1), VR(i), VR(i+1) entre lesquelles se situe Vin. Le convertisseur à interpolations successives CIT1, CIT2... CITk fournit sous forme numérique la position plus précise de Vin à l'intérieur de ce triplet.

Les bits de poids faible et les bits de poids fort sont ajoutés dans un additionneur non représenté pour aboutir à une valeur numérique globale de Vin.

On remarquera que le même pont de résistances sert à la conversion grossière (poids forts) de Vin et à la conversion fine (poids faible) du résidu.

Dans l'architecture représentée à la figure 1, on a prévu N amplificateurs AD(1) à AD(N) dont les sorties sont reliées aux 2N entrées d'un multiplexeur qui peut transmettre 3 paires de signaux au circuit CIT1. Mais on pourrait aussi prévoir que le multiplexeur ait N entrées et 3 sorties et soit placé immédiatement en sortie du pont de résistances, pour sélectionner 3 tensions de références VR(i-1), VR(i), VR(i+1) et les transmettre à l'entrée de 3 amplificateurs ADC, ADB, ADA. Dans ce cas il n'y a pas N amplificateurs parmi lesquels on en choisit trois, mais seulement trois amplificateurs recevant trois tensions de référence sélectionnées parmi N. Cela suppose cependant que le multiplexeur soit capable de transmettre à sa sortie, sans les altérer, les tensions de référence sélectionnées.

Selon l'invention, on propose, dans le cas général où la tension analogique est ainsi appliquée à l'entrée d'amplificateurs différentiels, de placer des échantillonneurs-bloqueurs à la sortie de ces amplificateurs, et de supprimer l'échantillonneur-bloqueur ECHB.

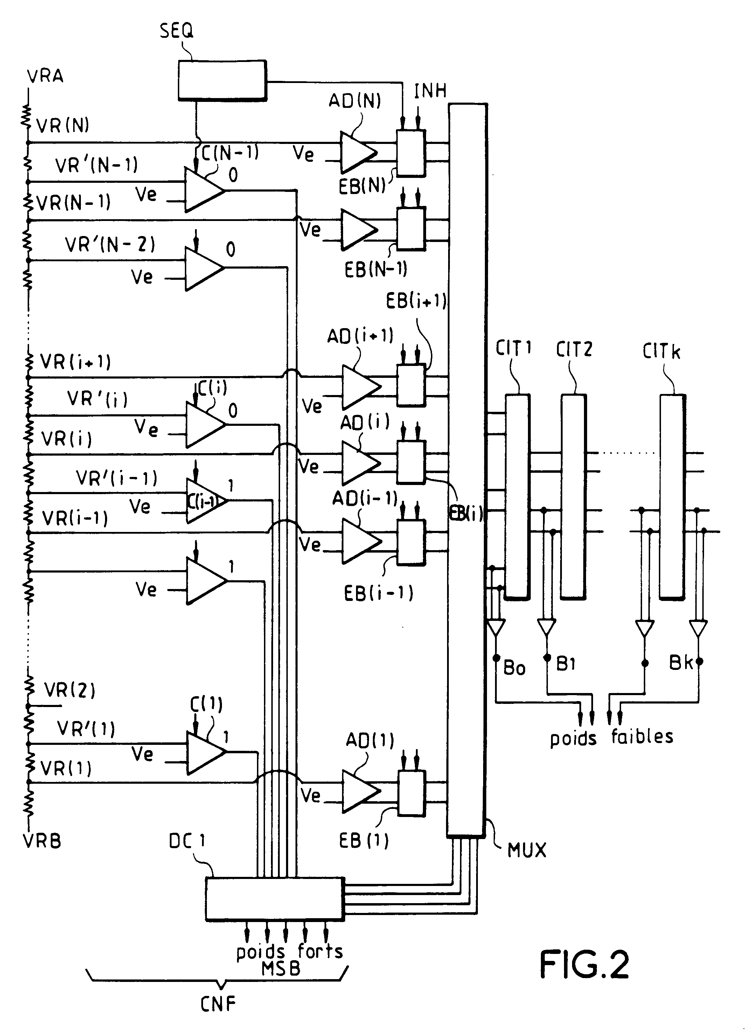

La figure 2 représente la réalisation correspondante dans le cas où on part du convertisseur de la figure 1, mais des schémas pourraient être établis de manière similaire en partant d'autres architectures.

Des échantillonneurs-bloqueurs EB1, ..., EB(i-1), EB(i), EB(i+1), ... EB(N) sont placés respectivement en sortie des amplificateurs AD(1)..., AD(i-1), AD(i), AD(i+1), ...AD(N).

Ces échantillonneurs-bloqueurs sont à structure différentielle; ils doivent commander des charges capacitives faibles, contrairement à l'échantillonneur-bloqueur ECHB de la figure 1. Ils n'ont donc pas besoin d'avoir une structure à forte consommation de courant.

Les échantillonneurs EB1 à EB(N) sont actionnés en phase avec la commande de conversion du convertisseur grossier CNF, pour que la tension échantillonnée à un moment donné à la sortie des amplificateurs différentielles soit celle qui correspond à la valeur de tension d'entrée Ve pour laquelle le convertisseur grossier fournit les bits de poids fort de la conversion.

En technologie MOS, les comparateurs C(1) à C(N-1) du convertisseur grossier peuvent être des comparateurs à capacités commutées travaillant en deux phases : une phase de précharge pour la prise en mémoire d'une tension dans une capacité d'entrée; dans cette phase le comparateur est rebouclé avec un gain unitaire et on stocke dans la capacité une tension de référence VR'(i) corrigée par la tension de décalage d'entrée du comparateur; et une phase de conversion dans laquelle la tension analogique Ve est effectivement appliquée au comparateur pour le faire basculer dans un sens ou l'autre. C'est l'instant de cette deuxième phase qui doit être synchronisé avec l'instant d'échantillonnage des échantillonneurs-bloqueurs EB(1) à EB(N). Ceci est figuré symboliquement par un circuit de séquencement SEQ qui commande à la fois les comparateurs et les échantillonneurs bloqueurs.

En technologie bipolaire, les comparateurs sont plutôt des amplificateurs différentiels suivis d'une bascule de mémorisation; ils fonctionnent aussi en deux phases : comparaison puis mémorisation, et c'est la phase de mémorisation qui doit être synchronisée avec l'instant d'échantillonnage.

Les échantillonneurs-bloqueurs sont ensuite bloqués jusqu'à la fin de la phase de conversion fine.

On peut éventuellement prévoir que les échantillonneurs bloqueurs peuvent être inhibés par une commande spécifique INH; dans ce cas, les sorties du décodeur DC1 peuvent servir à inhiber les échantillonneurs autres que ceux qui sont en sortie des amplificateurs AD(i-1), AD(i), AD(i+1) dont les sorties sont sélectionnées par le multiplexeur MUX. Les échantillonneurs inhibés ne consomment pas de puissance au moment de la phase d'échantillonnage, ce qui contribue à limiter la consommation globale de puissance du convertisseur.

L'invention est applicable dans d'autres configurations générales de convertisseurs que celle de la figure 2. Par exemple, le multiplexeur MUX pourrait être relié à un circuit d'interpolation parallèle et non série, comprenant des ponts de résistances placés entre les sorties du multiplexeur, avec des comparateurs pour comparer les niveaux de tension sur les prises intermédiaires de ces ponts.

L'invention serait applicable également dans le cas où le convertisseur fin comporte en sortie du pont de résistances principal non pas N amplificateurs différentiels ordinaires recevant la tension Ve à convertir, mais deux circuits de repliement de signal fournissant des tensions variant périodiquement et en quadrature de phase en fonction de la tension d'entrée Ve qui leur est appliquée.

## Revendications

1. Convertisseur analogique-numérique comportant un convertisseur grossier et un convertisseur fin, l'un des convertisseurs comportant plusieurs amplificateurs différentiels [AD(1) à AD(N)] recevant chacun d'une part une tension analogique à convertir (Ve) et d'autre part une tension de référence [VR'(1) à VR'(N)], caractérisé en ce qu'un échantillonneur bloqueur [EB(1) à EB(N)] est placé en aval de chacun des amplificateurs différentiels.

2. Convertisseur selon la revendication 1, caractérisé en ce que les échantillonneurs-bloqueurs sont activés en synchronisme avec la conversion par l'autre convertisseur.

3. Convertisseur selon l'une des revendications précédentes, caractérisé en ce que le convertisseur comportant des amplificateurs différentiels d'entrée est le convertisseur fin .

4. Convertisseur selon la revendication 3, caractérisé en ce que le convertisseur grossier est un convertisseur de type flash comportant plusieurs comparateurs actionnés simultanément pour comparer la tension analogique à des références de tension pendant une phase de conversion grossière.

5. Convertisseur selon la revendication 4, caractérisé en ce que les références de tension des comparateurs et les références de tension des amplificateurs différentiels sont définies par les prises intermédiaires d'un même pont de résistances.

6. Convertisseur selon l'une des revendications 4 et 5, caractérisé en ce que le convertisseur grossier fonctionne selon une phase de précharge et une phase de conversion, et en ce que la phase de conversion est faite simultanément avec une phase d'échantillonnage des échantillonneurs bloqueurs.

7. Convertisseur selon l'une des revendications précédentes, caractérisé en ce que le convertisseur fin comporte un pont de résistances définissant des tensions de référence [VR(i)], et des amplificateurs différentiels reliés à ce pont de résistances et recevant par ailleurs une tension à convertir (Ve), des moyens pour sélectionner trois amplificateurs différentiels en fonction d'un résultat de conversion grossière fourni par le convertisseur grossier, et un circuit d'interpolation fine en aval de ces amplificateurs, des échantillonneurs-bloqueurs étant placés entre les amplificateurs différentiels sélectionnés et le circuit d'interpolation fine.

8. Convertisseur selon la revendication 7, caractérisé en ce que des échantillonneurs bloqueurs sont placés en aval de tous les amplificateurs différentiels et en ce que des moyens sont prévus pour inhiber les échantillonneurs-bloqueurs reliés aux amplificateurs différentiels non sélectionnés.

9. Convertisseur selon l'une des revendications 1 à 6, caractérisé en ce que le convertisseur fin comporte un pont de résistances et des amplificateurs différentiels à repliement de signal recevant d'une part des tensions de référence définies par ce pont et d'autre part la tension analogique à convertir, et en ce que les échantillonneurs-bloqueurs sont reliés aux sorties des amplificateurs à repliement de signal.
